# EUROPEAN PATENT SPECIFICATION

(11) **EP 4 555 357 B1**
(45) Date of publication and mention of the grant of the patent: **30.09.2026**
(21) Application number: 22757638.6
(22) Date of filing: 11.07.2022
(51) Int. Cl.: G01V 20/00

(54) **METHOD FOR MODELLING DEPOSITION OF SEDIMENTS IN AN AREA SUBJECT TO STORMY CONDITIONS**
VERFAHREN ZUR MODELLIERUNG DER ABLAGERUNG VON SEDIMENTEN IN EINEM BEREICH UNTER STURMBEDINGUNGEN
PROCÉDÉ DE MODÉLISATION DE DÉPÔT DE SÉDIMENTS DANS UNE ZONE SOUMISE À DES CONDITIONS DE TEMPÊTE

(43) Date of publication of application: 21.05.2025
(73) Proprietor: TotalEnergies OneTech, 92400 Courbevoie (FR)
(72) Inventor: MASSONNAT, Gérard, 64018 Pau Cedex (FR); LEMAY, Martin, 64018 Pau Cedex (FR); DANQUIGNY, Charles, 64018 Pau Cedex (FR)
(74) Representative: Plasseraud IP
(86) International application number: PCT/IB2022/000397
(87) International publication number: WO 2024/013530

(56) References cited:
- WO-A1-2020/229863
- XIAO Z Y ET AL: "Numerical modelling of suspended-sediment transport in a geographically complex microtidal estuary: Sydney Harbour Estuary, NSW", ESTUARINE, COASTAL AND SHELF SCIENCE, NEW YORK, NY, US, vol. 236, 29 January 2020 (2020-01-29), XP086080763, ISSN: 0272-7714, [retrieved on 20200129], DOI: 10.1016/J.ECSS.2020.106605
- ISRAEL E. HERRERA-DÍAZ ET AL: "Light Particle Tracking Model for Simulating Bed Sediment Transport Load in River Areas", MATHEMATICAL PROBLEMS IN ENGINEERING, vol. 2017, 1 January 2017 (2017-01-01), CH, pages 1 - 15, XP055655132, ISSN: 1024-123X, DOI: 10.1155/2017/1679257
- MITCHELL D A ET AL: "Observed currents over the outer continental shelf during Hurricane Ivan", THE 3RD EAA EUROPEAN CONGRESS ON ACOUSTICS (FORUM ACUSTICUM 2002), JOHN WILEY & SONS, INC, SEVILLA, SPAIN, vol. 32, no. 11, 11 June 2005 (2005-06-11), pages n/a, XP071421470, ISSN: 0094-8276, DOI: 10.1029/2005GL023014

## Description

### TECHNICAL FIELD

The invention relates to a computer-implemented method for modelling transport and deposition of sediments in an immersed area subject to stormy conditions.

### TECHNICAL BACKGROUND

Forward stratigraphic modelling is already known for modelling the evolution of sedimentary basins. In this type of modelling, an area is defined as a geological gridded model, and the modelling comprises superposing layers on the gridded model, each layer corresponding to a predetermined period of time and having a thickness which depends on an amount of material brought or created at a defined location during the period of time.

An example of forward stratigraphic modelling is for instance the DionisosFlow^{™} numerical stratigraphic model developed by IFP Energies Nouvelles, which allows reconstructing the stratigraphic architecture of sedimentary basins at a regional scale, by modelling basin deformation, clastic and carbonate supplies and sediment transport in continental and marine environment.

This model is used to simulate areas of regional scale, i.e. having dimensions of about tens to hundreds of kms side length, and on very long time scales. Each time layer simulated in this model is of at least 1000 years, up to 10.000 years, in order to model phenomena occurring on durations of at 100.000 years to several million years.

In order to be able to compute phenomena on such large geographical and time scales, the algorithms implemented by this model for simulating the transport of particles are only based on advection and diffusion. This implies that the geological phenomena which are simulated in forward simulators like DionisosFlow^{™} are necessarily continuous and homogeneous, and hence they cannot render local heterogeneities, which limits their potential for instance to precisely model the formation of oil reservoirs.

On the other hand, some models also exist to simulate phenomena which are more localized both in time and space, such as snow avalanches, sedimentation dynamics within rivers and deltas, etc. These models are based on equations modelling the motion of fluids such as Navier-Stokes equations. These models require a high computational load as compared to the time scale of the modelled phenomena, since the modelling of a phenomena requires a computational time of 1,5 times the duration of the modelled phenomena. Hence these times of models are not suitable for modelling the formation of reservoirs.

It is also known from WO 2020/229863, WO 2020/229862, WO 2020/229866 and WO 2020/229865 methods for modelling the evolution of sedimentary basins by simulating current-induced particle transport. These methods are forward stratigraphic modelling methods enabling to model the deposition of time-layer of sediments corresponding to an amount of time that is less than the duration of a time-layer of DionisosFlow^{™}, for instance between a few 100 years and a few 10.000 years. The methods disclosed in these documents allow modelling the transport of particles based on current transport and takes into account the possible interaction between several phenomena or several types of current transport.

These methods can handle possible changes of currents conditions from one time-layer to another. However, they do not render the impact of stormy weather conditions potentially frequent and of short duration on the sedimentation processes.

Xiao, Z.Y. et al., in "Numerical modelling of suspended-sediment transport in a geographically complex microtidal estuary: Sydney Harbour Estuary, NSW", ESTUARINE, COASTAL AND SHELF SCIENCE, NEW YORK, NY, US, vol. 236, 29 January 2020, describes the modelling of sedimentary deposition taking into account sediment dynamics by measuring the suspended sediment concentration in water and turbidity for a complex estuary geometry. The simulation includes two storm events.

### SUMMARY OF THE INVENTION

An aim of the invention is to provide a method taking into account the impact of stormy weather conditions in sedimentation processes, for frequent events which duration is much shorter than the one of time-layers. In particular, an aim of the invention is to provide a method for modelling transport and simulation of sediments in an immersed area, where both fairweather conditions and stormy conditions can be rendered.

Accordingly, a computer-implemented method of modelling the sedimentary deposition within an immersed area subject to stormy meteorological events, comprises:
- a setup comprising defining a geological gridded model of the immersed area, a period of time during which sedimentary deposition is modelled, a reference water level, at least one supply process of particles to be introduced within the model, at least one water current type occurring within the immersed area and a duration of stormy conditions within the period of time, and
- simulating the evolution of the geological gridded model over the period of time, comprising:
   ∘ assigning a water depth to a plurality of cells,
   ∘ introducing at least one particle in at least one cell of the geological gridded model,
   ∘ determining a transport of at least one introduced particle induced by the water current in fairweather conditions, wherein the transport of a particle comprises displacing the particle or depositing the particle on water bottom,
   ∘ modelling remobilization of a fraction of the deposited particles following occurrence of stormy conditions,
   ∘ determining a transport of the remobilized fraction of particles induced by the water current in stormy conditions, wherein the transport of a particle comprises displacing the particle or depositing the particle on water bottom and
   ∘ updating a topography of the geological gridded model of the area according to the transport of the particles.

In the invention, the steps of determining a transport of the introduced particles and remobilized particles are repeated until all introduced particles are deposited or have exited the gridded model.

The method also comprises extracting data from the updated model to be compared with observed data acquired from a well.

In embodiments, determining the transport of a particle comprises:
- determining a direction and velocity of the at least one water current within the immersed area,
- determining, from the direction and velocity of the water current, a direction and intensity of a shear stress induced by the water current, and
- determining that the particle is transported or deposited based on the determined direction and intensity of the shear stress, a granulometry and sediment type of the particle.

In embodiments, modelling remobilization of a fraction of the deposited particles comprises determining the fraction of the deposited particles which is remobilized during a stormy event. In embodiments, the setup further comprises defining a wind speed associated to stormy conditions, and determining the fraction of the deposited particles which is remobilized during a stormy event comprises:
- determining a velocity of at least one water current induced by the wind within the immersed area during a stormy event,
- Determining, from the velocity of the water current, a value of a shear stress induced on the deposited particles by the wind-induced water current and,
- Determining the fraction of the deposited particles which is remobilized during the stormy event based on said shear stress value.

In embodiments, the method further comprises a preliminary step of defining water layers corresponding to respective water depths ranges extending between the surface and the bottom of the immersed area, comprising:
- A bottom layer, located at water bottom,
- A plume layer, located at water surface, and
- A subsurface layer, extending between the bottom and the plume layer,
and modelling remobilization of a fraction of the deposited particles comprises determining a fraction of particles remobilized in each water layer.

In embodiments, determining a velocity of at least one water current induced by the wind within the immersed area under stormy conditions comprises:
- Determining the velocity of a wind-induced current occurring in the plume layer based on parameters inferred from the wind speed, and
- Determining the velocity of a return current occurring in the subsurface layer and resulting from the wind-induced current occurring in the plume layer.

In embodiments, determining a velocity of a wind-induced current occurring in the plume layer comprises determining a velocity of one of an ocean surface current caused by an Ekman vortex and a wave-induced current.

In embodiments, determining a fraction of particles remobilized in each water layer is based on the shear stress value induced on the particles in the bottom layer, a shear stress value induced on the particles in the considered water layer and at least one shear stress threshold value.

In embodiments, all the remobilized particles are remobilized in the bottom layer if:
- the shear stress value in the bottom layer is higher than a motion shear stress threshold value of the particles, and
- the shear stress value in the subsurface layer is lower than a critical suspension shear stress value of the particles.

In embodiments, a fraction of remobilized particles is suspended in the subsurface layer if:
- the shear stress value in the bottom layer is higher than a motion shear stress threshold value of the particles, and
- the shear stress value in the subsurface layer is greater than a critical suspension shear stress value of the particles.

In embodiments, a fraction of the remobilized particles is suspended in the plume and subsurface layer:
- the shear stress value in the bottom layer is higher than a motion shear stress threshold value of the particles,
- a shear stress value in the subsurface layer is higher than a suspension shear stress threshold value of the particles, and
- a shear stress value in the plume layer is higher than the suspension shear stress threshold value of the particles.

According to another aspect, a computer program product is disclosed, comprising code instructions for implementing the method according to the above description, when it is executed by a processor.

According to another aspect, a non-transitory computer readable storage medium is disclosed, having stored thereon a computer program comprising program instructions, the computer program being loadable into a processor and adapted to cause the processor to carry out, when the computer program is run by the processor, the method according to the above description.

The method allows rendering the impact of stormy conditions on the deposition of sediments. In particular, the method comprises simulating the transport and deposition of sediments during a period of time comprising days of fairweather conditions and days of stormy condition, and the remobilization, caused during the days of stormy conditions, of a fraction of the sediments deposited under fairweather conditions.

### BRIEF DESCRIPTION OF THE DRAWINGS

The present invention is illustrated by way of example, and not by way of limitation, in the figures of the accompanying drawings, in which like reference numerals refer to similar elements and in which:
- Figure 1 is an exemplary representation of a geological gridded model of an area, showing a first time-layer and a cut view of the superposition of other time-layers over the first, where the grey level of the cells indicates the water depth of each cell.
- Figure 2 is a flow chart describing a method for modelling sedimentary deposition of particles, taking into account occurrence of exceptional stormy events,
- Figure 3 is a representation of the decomposition of an immersed area into three water depths ranges.
- Figure 4a schematically represents the evolution of ocean surface current velocity and wave velocity in the plume layer.
- Figure 4b schematically represents the evolution of ocean surface current velocity and wave velocity in the subsurface layer.
- Figure 5 Schematically represents the wind-induced currents and the evolution of their velocities according to water depth.
- Figure 6a represents the value of an avalanche angle as a function of grain size,
- Figure 6b represents the gravity-induced shear stress as a function of granulometry and topographic slope,
- Figure 7a to 7d represent Shields diagrams showing whether a particle is deposited or transported according to its size and the shear stress applied to the particle, for four types of particles,
- Figure 7e to 7h represent Shields diagrams showing whether a particle is remobilized according to its size and the shear stress applied to the particle, for four types of particles
- Figures 8a to 8d represent controlling factors for flocculation process,
- Figure 9 represents the distribution of particles before and after modelling a flocculation process.
- Figure 10 is a possible embodiment for a device that enables the present invention.
- Figure 11a is an illustration of a model output by the method, showing a first time-layer and a cut view of the superposition of other time-layers over the first, where the grey level of the cells indicates the remobilized fraction of particles following stormy events,
- Figure 11b represents the same model as figure 11a but the grey level of the cells indicates the fraction of remobilized particles which are transported in the bottom layer.

### DESCRIPTION OF PREFERRED EMBODIMENTS OF THE INVENTION

The method described below models the evolution of sedimentary basins by simulating the deposition over time of clastic and/or carbonates particles that can be supplied or produced by diverse processes such as rivers, travertine sources, in-situ production of carbonates, remobilization of carbonates, etc. This method also takes into account the impact of water currents on the transport of clastic and carbonates particles. The sedimentary area to be modelled can be either a marine area, or a lacustrine area.

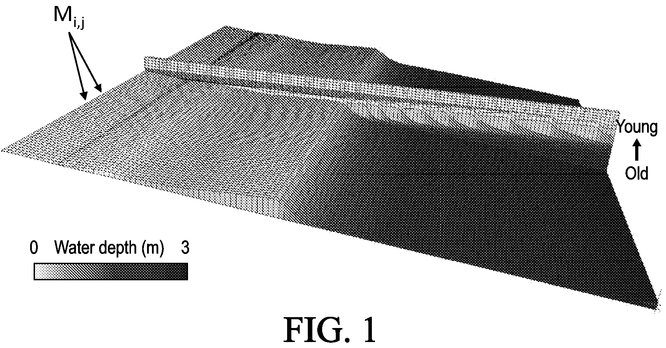

The method is a forward stratigraphic modelling method, modelling the evolution of an immersed sedimentary area through the deposition of successive layers of sediments. Accordingly, the sedimentary area is formed by a stack of layers, wherein each layer is defined by a two-dimensional surface representing the surface of the ground of the immersed area at the time of deposition of sediments, and by a thickness of sediments forming said layer. Each layer is gridded and comprises, like in the example shown in figure 1, a plurality of grid cells M_{1,1}, M_{1,2}, M_{2,1},..., and more generally M_{i,j}, where the variables i and j indicate the positions of the cells within the surface. Each layer if further associated to a time t corresponding to a time of deposition of sediments. Accordingly, each cell of the modelled area can be described by three parameters (i, j, k) or (x,y,t) wherein the two first coordinates represent the location of the cell within the surface and k represents the time layer or t represents the time of formation of the surface, which is equivalent.

Typically, each cell represents an area having a side length of a few hundreds of meters, up to a few kilometers. The method starts with an initial topography corresponding to an initial surface representing the bottom of the immersed area, above which a column of water of defined height (i.e. water depth of each cell of the model) is defined, and comprises iterating a series of steps modelling the introduction into the model of clastic and/or carbonates particles during a predetermined period of time T, their transport induced by water currents during this period of time T, and the deposition of some of these particles to form an additional layer of sediments.

At the end of this period of time T, the topography of the model is updated in each cell according to the quantity of deposited particles. More specifically, a layer is generated, which thickness in each cell is determined based on a number of particles deposited at this cell. Such a layer is called a time layer since it corresponds to the passage of the predetermined period of time T. The topography of the geological gridded model of the area thus evolves with the accumulation of time layers.

The example shown in figure 1 represents the gridded model in which the main represented surface is a time-layer and a cross-section of the stack of superposed time-layers is also shown. The height of a cell represents the thickness of the deposited layer of sediments and hence the topography of the area. Moreover, the grey level of each cell represents its water depth at the considered time layer. In this example one can notice that the water-depth of the cells located on the right-hand side of the model is progressively reduced until being equal to 0 due to the successive deposition of sediments and hence the emersion of the corresponding land. Once the land is emerged the topography of the model no longer evolves since it is no longer subject to sedimentation.

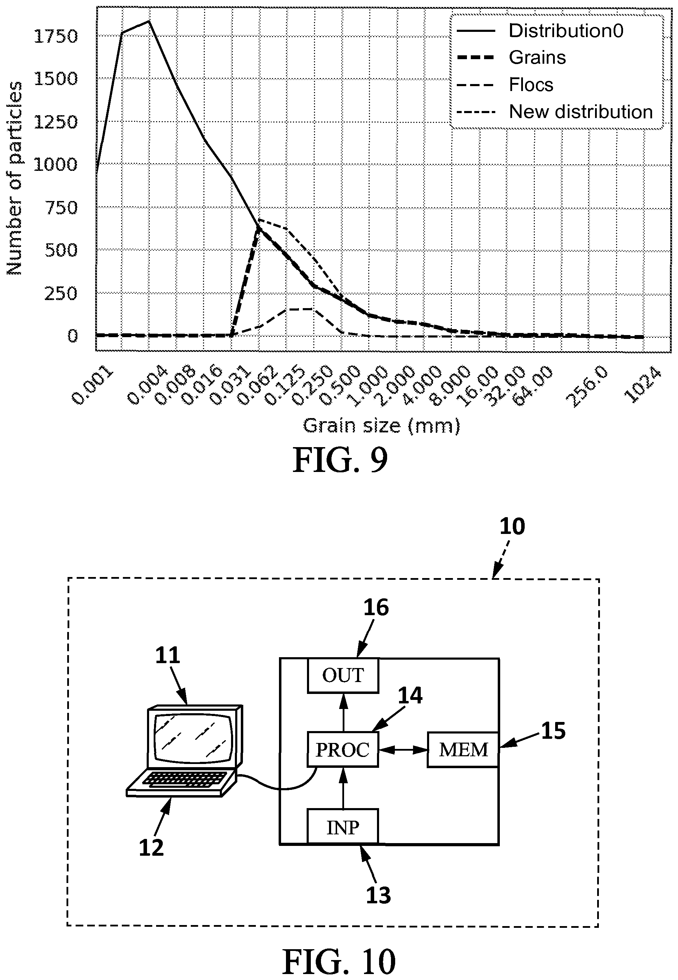

The method of modelling sedimentary deposition within an immersed area is a computer-implemented methods. With reference to figure 10 is shown a possible embodiment for a device that enables the present invention.

In this embodiment, the device 10 comprises a computer, this computer comprising a memory 15 to store program instructions loadable into a circuit and adapted to cause circuit 14 to carry out the steps of the present invention when the program instructions are run by the circuit 14. The memory 15 may also store data and useful information for carrying the steps of the present invention as described above.

The circuit 14 may be for instance:
- a processor or a processing unit adapted to interpret instructions in a computer language, the processor or the processing unit may comprise, may be associated with or be attached to a memory comprising the instructions, or
- the association of a processor / processing unit and a memory, the processor or the processing unit adapted to interpret instructions in a computer language, the memory comprising said instructions, or
- an electronic card wherein the steps of the invention are described within silicon, or
- a programmable electronic chip such as a FPGA chip (for « Field-Programmable Gate Array »).

This computer comprises an input interface 13 for the reception of several data used for the above method according to the invention, for instance the gridded model, some parameters of the topography of the modelled area, some parameters of the modelled currents, etc. This computer also comprises an output interface 16 for outputting the updated geological gridded model.

To ease the interaction with the computer, a screen 11 and a keyboard 12 or a tactile screen may be provided and connected to the computer circuit 14. The various components described above may be remotely connected to one another, i.e. the memory storing the data and/or the circuit implementing the method may be remotely located with reference to the user and accessible through any suitable network.

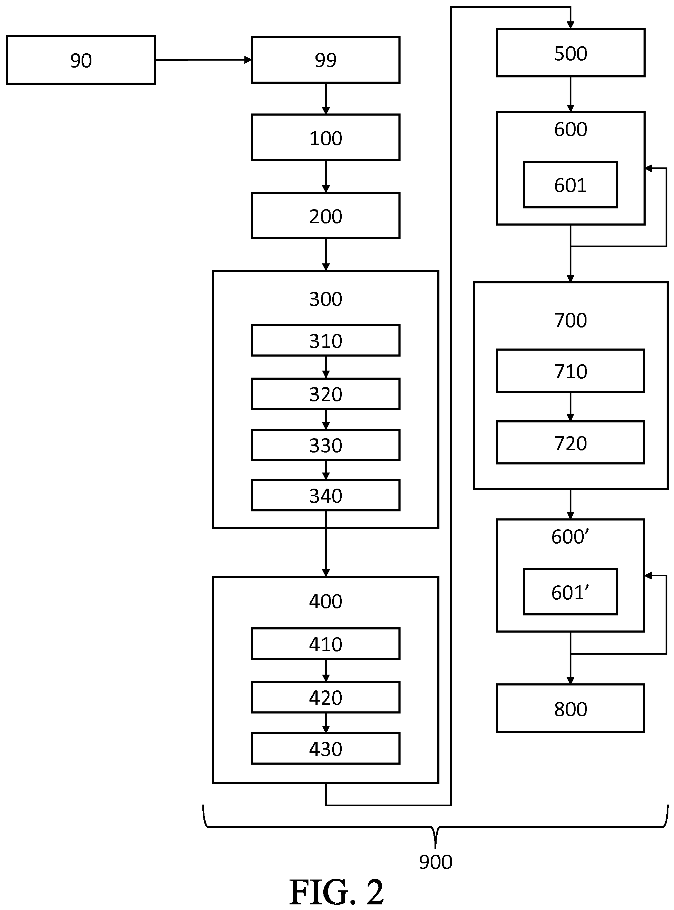

With references to figure 2 the main steps of a method for modelling sedimentary deposition within an immersed area will now be disclosed.

### Setup step

The method for modelling sedimentary deposition comprises a first preliminary setup step 90. The setup step comprises initializing a topography of the modelled area, i.e. receiving an initial surface having a plurality of cells wherein each cell corresponds to a position (x,y) and is assigned a parameter z0 which is the height of said bottom surface. The setup step also comprises defining the period of time T corresponding to one time layer, i.e. the period of time during which introduction of particles representing sediments, transport and deposition of these particles is simulated and, possibly, iterated. Preferably, this duration may be comprised between 1000 and 100.000 years.

The setup step also comprises setting an initial reference water level zᵣ, as well as the evolution of the reference water level over the model between two successive periods of time T, i.e. two successive time layers (eustatism for marine areas) and the amount of subsidence of the ground's surface over the geological gridded model between two time layers. The amount of subsidence may vary over the model of the area, i.e. it may not be the same for all the cells of the models.

From the initial topography of the geological gridded model and the initial reference water level, a water depth WD in each cell is inferred and assigned to the respective cell. If the height z₀ of a cell is above the reference water level zᵣ, then the water depth is zero. It can be understood that as the method aims at modelling the evolution of a sedimentary area, at least some of the cells of the initial topography are below water level, i.e. z₀<zᵣ.

The setup step 90 also includes the user defining the number and types of particles supply or production processes, the number and types of water currents to be modelled, and the parameterizing of each particle supply or production process and of each current. Regarding the particles supply or production processes, each particle introduced within the model may result from either a carbonate production model or a siliciclastic supply process. Carbonates production processes comprise:
- carbonates from underwater factories,
- aerial travertine,

Siliciclastic supply processes comprise:
- river mouth supply,
- volcanoes supply,

The parameterization of production of carbonates may comprise defining a sedimentary element type, granulometry, and production rate of the carbonate production. The production rate may itself depend upon environmental factors which may also be set by the user, such as bathymetry, current energy, water temperature, chemistry, etc.

The parameterization of each siliciclastic supply process may comprise defining a location of the source of elements (location of the volcano, river mouth, etc.) sedimentary element type, granulometry, and rate of supply of the considered process, i.e. a volume or mass of supplied sedimentary elements per time unit.

During the subsequent modelling of the supply or production processes, the sedimentary elements are introduced in the model as particles where each particle represents a determined mass or volume of siliciclastic or carbonates sediments of a defined granulometric class. Regarding the currents to be modelled, the user may choose to model at least one among the following water currents:
- wind-induced current, including wind-induced wave current and oceanic surface current,
- tidal current,
- river-mouth induced current.

Oceanic surface current can only apply for marine areas, whereas the other currents, including tidal current, can apply for both marine and lake areas. If wind-induced currents are modelled, then the setup step also comprises setting up a celerity vector of the wind *̅u̅_̅{̅w̅i̅n̅d̅}̅*̅, comprising setting a direction and an absolute value of the wind celerity.

If at least one river mouth induced current is to be modelled, the setup step 90 can comprise the user setting the volumetric flow of the river at the river mouth, the width and depth of the river mouth.

The modelling of sedimentary deposition also comprise simulating the impact of exceptional weather events, i.e. storms, floods, etc., that are prone to remobilize sediments that have already been deposited. Accordingly, the setup step 90 also comprises defining a duration of stormy conditions over the time period T, expressed for instance as a number of days of stormy conditions per year. If wind-induced currents are modelled, a celerity vector of the wind *̅u̅_̅{̅w̅i̅n̅d̅,̅s̅t̅o̅r̅m̅}̅*̅ in stormy conditions may also be defined during this setup step. By contrast, the celerity vector of the wind *̅u̅_̅{̅w̅i̅n̅d̅}̅*̅ introduced above relates to the parameters of the wind in fair weather conditions, i.e. during the rest of the days of the year.

The method then comprises a series of steps which are detailed below, and which are implemented to generate one time layer, representing the passage of the predetermined period of time T.

### Computation layer

The series of steps which forms one computation layer, and which is implemented at least once to generate a time layer representing the period of time T, or iterated a number N of times in the embodiments described above, is designated by reference 900 on figure 2, and will now be described.

An optional preliminary step 99 comprises the change of some parameters of the model by the user, if it is desired to represent an evolution of these parameters between one period of time represented by a time layer T and another. For instance, the parameters regarding the river mouth current that can be set at step 90 (volumetric flow, width and height at the river mouth) can be modified at step 99. Also, the parameterization of each supply or production process may be changed at optional step 99.

The eustatism and subsidence rate may also be amended between two time-layers during said preliminary step 99.

Step 100 comprises receiving the geological gridded model of the area, either by loading an initial version of the model, or by updating the model according to a previous iteration of the series of steps 900. The update comprises updating a height along z of each cell, which corresponds to the initial position z₀ of the cell along z added to the thickness of particles deposited at the cell. The height along z may also take into account local subsidence of the ground's surface.

The method then comprises a step 200 of computing, from the topography updated at step 100, topographic slopes of the ground surface formed by the model and inferring, from the topography and reference water level zᵣ, the water depth WD in each cell.

The method then comprises a step 300 of modelling marine water currents occurring over the immersed area represented by the gridded model. This step is performed by determining, for a plurality of cells of the gridded model for which WD >0, and preferably each cell for which WD>0, a direction and velocity of each water current to be modelled. The shoreline SL is defined by cells for which WD=0 and which are adjacent cells for which WD>0.

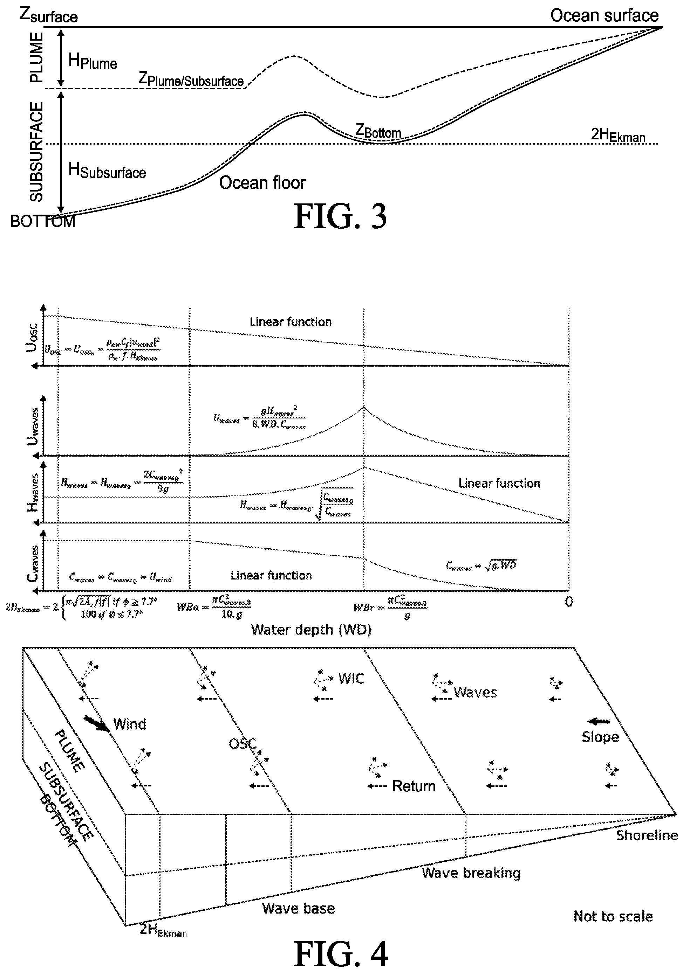

For the computation of direction and velocity of each water current, and with reference to figure 4, the extent of water extending over the ground surface is decomposed into three water layers or respective depths, comprising a bottom layer, extending at water bottom, a plume layer, extending at water surface, and a subsurface layer extending between the plume layer and the bottom layer.

More specifically, the thickness of the bottom layer is constant and corresponds to the boundary layer for the subsurface flow. It is preferably comprised between a few mm and a few cm. It may be set by the user or defined per default. According to a non-limiting example, the thickness of the bottom layer may be set equal to 0.01 meter. The bottom layer thus extends between the ground surface and a fixed distance thereof.

The thickness of the plume layer is determined based on the thickness of Ekman layer. Ekman layer is the layer in a mass of fluid on Earth where there is a force balance between pressure gradient force, Coriolis force and turbulent drag. The thickness of the Ekman layer depends upon the latitude and is expressed as follows: ${H}_{Ekman} = \left\{\begin{matrix}π \sqrt{2 {A}_{z} / \left|f\right|} if ϕ \geq 7.7 ° \\ 100 if ∅ \leq 7.7 °\end{matrix}\right.$

Where A_{z} = 0,01m²/s, f=Ω.sin(Φ) and Ω = 7,3.10⁻⁵rad/s.

The thickness of the plume layer, i.e. the limit between the plume and subsurface layer, is set to be at most equal to *H_{Ekman}* computed above if the water depth in a given cell is at least 2*H_{Ekman}*. Otherwise, the thickness of the plume layer is equal to WD/2 as summarized below: ${z}_{plume / subsurf} = \left\{\begin{matrix}{z}_{surface} - {H}_{Ekman} & if WD \geq 2 {H}_{Ekman} \\ {z}_{surface} - \frac{WD}{2} & if WD \leq 2 {H}_{Ekman}\end{matrix}\right.$

An example of decomposition into three water layers depending on the water depth of the ground surface and the thickness of the Ekman layer is shown in figure 3.

Computing 300 the direction and velocity of currents occurring within the immersed area thus comprises determining 310 the thickness of the Ekman layer, decomposing the water into three water layers 320, and then determining 330 a direction and velocity of currents occurring within the plume layer, and within the subsurface layer. In the bottom layer, the velocity of currents is not computed since it is considered as the boundary layer of the subsurface current. As indicated above, one or more currents may be simulated among: wind-induced currents, which comprise ocean surface current and wave-induced current, river-mouth current and tidal current. Accordingly, a celerity vector may be determined for each current in the plume and subsurface layer.

The celerity vector of the wind-induced currents in the plume layer *̅U̅_̅{̅W̅I̅C̅,̅p̅l̅u̅m̅e̅}̅*̅ is the sum of the celerity vectors of the ocean surface current *̅U̅_̅{̅O̅S̅C̅,̅p̅l̅u̅m̅e̅}̅*̅ and the wave-induced current *̅U̅_̅{̅w̅a̅v̅e̅s̅,̅p̅l̅u̅m̅e̅}̅*̅: $\vec{{U}_{WIC , plume}} = \vec{{U}_{OSC , plume}} + \vec{{U}_{waves , plume}}$

Ocean surface current is the current induced in the water surface by the wind, inducing a water displacement within the Ekman layer.

In the plume layer, the direction of displacement of water induced by the ocean surface current (hereinafter denoted "OSC" in indexes) is perpendicular to the direction of the wind, towards the right (i.e. clockwise direction) in the Northern hemisphere and towards the left (i.e. counterclockwise direction) in the Sourthern hemisphere: $\vec{{U}_{OSC , plume}} = \left\{\begin{matrix}\vec{{U}_{{OSC}_{0}}} = \pm \frac{{ρ}_{air} {C}_{f} {\left|{u}_{wind}\right|}^{2}}{{ρ}_{w} . f . {H}_{Ekman}} ⋅ \left(-{Dir}_{{wind}_{y}},{Dir}_{{wind}_{x}}\right) if WD \geq 2 {H}_{Ekman} \\ \vec{{U}_{{OSC}_{0}}} . \frac{WD}{2 {H}_{Ekman}} if WD \leq 2 {H}_{Ekman}\end{matrix}\right.$

Where *Dir_{windₓ}* and *Dir_{wind_{y}}* are the coordinates in x and y of the wind speed vector, *ρ_{w}* and *ρₐᵢᵣ* are the volumetric masses of water and air, respectively, in kg/m³, C_{f} = 0.0015 is the friction coefficient of water surface. The norm of the vector *U_{OSC,plume}* is the velocity value of the OSC current in the plume layer in a considered cell. It is an average value over the thickness of the plume layer.

In the plume layer, the wave-induced current is parallel to the direction of the wind and only occurs from the surface down to a determined depth WD_{base} called wavebase water depth, so by definition this wave-induced current only occurs in cells in which the water depth WD is below WD_{base}. WD_{Base} may be computed as follows: ${WD}_{base} = \frac{{λ}_{wave}}{2}$

Where λ_{wave} is the wave wavelength induced by the wind and may be inferred from the wind speed by use of a wave model such as the Airy linear model.

A wave breaking water depth is also defined as: ${WD}_{wavebreaking} = \frac{{λ}_{wave}}{20}$

When stormy events are simulated these parameters have to be computed for both stormy and fairweather conditions.

The velocity of the wave-induced current is computed from the height of the waves and the celerity of the waves.

The height of the waves is computed as follows: ${H}_{waves} = \left\{\begin{matrix}{H}_{{waves}_{0}} = \frac{2 {{C}_{{waves}_{0}}}^{2}}{9 g} if WD = {WD}_{base} \\ {H}_{{waves}_{0}} . \sqrt{\frac{{C}_{{waves}_{0}}}{{C}_{waves}}} if {WD}_{wavebreaking} \leq WD \leq {WD}_{base} \\ linear interpolation between {H}_{{waves}_{0}} . \sqrt{\frac{{C}_{{waves}_{0}}}{{C}_{waves}}} and 0 if WD \leq {WD}_{wavebreaking}\end{matrix}\right.$

The celerity of the waves is computed as follows: $\begin{matrix}{C}_{waves} \\ = \left\{\begin{matrix}{C}_{{waves}_{0}} = {U}_{wind} if WD = {WD}_{base} \\ \sqrt{g . WD} if WD \leq {WD}_{wavebreaking} \\ Linear interpolation between {C}_{{waves}_{0}} and \sqrt{g . {WD}_{wavebreaking}} if {WD}_{wavebreaking} \leq WD \leq {WD}_{base}\end{matrix}\right.\end{matrix}$

The velocity vector of the wave induced current is thus null if WD>WD_{base} and equal, when WD ≤ WD_{base} to: $\vec{{U}_{waves , plume}} = \frac{{{gH}_{waves}}^{2}}{8 . WD . {C}_{waves}} \vec{{Dir}_{wind}}$

The norm of the vector *U_{waves,plume}* is the velocity of the wave-induced current in the plume layer in a considered cell. It is an average velocity over the thickness of the plume layer. Additionally, when the water depth WD is below twice the thickness of the bottom water layer, the velocity of the wave-induced current is set to zero to prevent numerical divergence. Figure 4a provides a summary of the ocean surface current velocity and wave induced current velocity in the plume layer.

In embodiments, the modelling of wind-induced currents may also comprise modelling a fetch distance. Indeed, the waves are formed only when the wind blows on wide enough areas. Thus when the wind blows from the sea towards the shore line, it is considered that the wave-induced current and oceanic surface current appear in all the cells until the shoreline according to the above equations. When by contrast the wind blows from the shoreline towards the sea, a fetch distance is computed from the shoreline, which value is defined by: $Fetch = 0.20 . {{U}_{wind}}^{0.57}$

If the water depth of the cells is lower than WD_{base} from the shoreline to the fetch distance, the celerity of the waves linearly increases from 0 on the shoreline until Uwaves computed according to the equation above at the fetch distance. If the water depth is higher than WD_{base} then the wave celerity is null.

Regarding the ocean surface current, the latter increases linearly from 0 at the shoreline until reaching the velocity Uosc computed according to the equation above at the fetch distance. Regarding wind-induced currents, the direction and velocity of these currents in the subsurface layer can be inferred at substep 340 from the direction and velocity respectively of the currents in the plume layer.

In the subsurface layer, with reference to figure 4b, the wind-induced currents are return currents (denoted *̅U̅_̅{̅r̅e̅t̅u̅r̅n̅,̅s̅u̅b̅s̅u̅r̅f̅a̅c̅e̅}̅*̅) from the wind-induced currents occurring in the plume layer.

Accordingly, the velocity vectors of said return currents extend parallel to the topographic slope in the considered cell, i.e. the vector of maximum slope of the ground surface in the cell, and in a direction opposed to the direction of the component of the respective velocity vector of the wind induced currents within the plume layer that is parallel to the slope. It is assumed that the component orthogonal to the slope of the wind-induced currents within the plume layer - i.e. longshore component - keeps flowing away from the considered cell.

The subsurface velocity vector is thus inferred from the component of the velocity of the wind-induced currents in the plume layer which is parallel to topographic slope as follows, $\vec{{U}_{return , subsurface}} = - \left(\vec{{U}_{WIC}}.\vec{Slope}\right) . \vec{Slope} . \frac{{H}_{plume}}{{H}_{subsurface}}$

*Slope* is the unitary vector of maximum descending slope in the considered cell.

If, in addition to the wind-induced currents, the modelled currents also comprise a river-mouth induced current and/or a tidal current, then:
- the directions and velocities of the river-mouth induced current in the plume and in the subsurface layers may also be determined by implementing the method disclosed in WO 2020/229865,

In particular, the velocity of a river-mouth induced current depends on the flow type of the river and the position of the considered cell with respect to the width of the river jet. The river jet type may be either homopycnal, hypopycnal and hyperpycnal and may be determined based on a comparison between the density of the river jet (water and sedimentary discharge) and the density of the water in which the river flows. The velocity vector of river-mouth induced current extends perpendicular to the direction along which extends the width of the river mouth, and extending away from the river mouth, and the velocity of the current Uᵣᵢᵥₑᵣ is denoted as u in WO2020/229865.
- the direction and velocity of the tidal current may also be determined by implementing the method disclosed in WO 2020/229866.

In particular, as developed in this document, modelling the tidal current implies decomposing each time layer into an even number of 2k computation layers corresponding to subperiods of time of duration T/2k where half of the subperiods correspond to rising tide and the other half corresponds to the falling tide. The direction of the tidal current is towards the shoreline during rising tide and away from the shoreline during falling tide. The velocity of the tidal current U_{tidal} in the plume layer increases from 0 at the high tide shoreline to a maximum value (which may be user-defined) at a distance from the shoreline such that WD=zᵣ in the cell, and then decreases again until reaching 0 in cells where WD=WD_{TD} where WD_{TD} is the water depth of influence of the tidal current. The velocity of the tidal current in the subsurface layer is computed from the velocity of the tidal current in the plume layer of the same cell by applying a decrease factor which is function of water depth.

The method then comprises determining 400 a direction and intensity of shear stress induced by the modelled water currents in each water layer. The intensity of a shear stress in a water layer is a depth-averaged intensity over the height of said water layer. It is thereafter denoted:
- *̅τ̅ₚ̅ₗ̅ᵤ̅ₘ̅ₑ̅*̅ a shear stress induced by simulated currents on particles in the plume layer,
- *̅τ̅_̅{̅s̅u̅b̅s̅u̅r̅f̅a̅c̅e̅}̅*̅ a shear stress induced by simulated currents on particles in the subsurface layer, and
- *̅τ̅_̅{̅b̅o̅t̅t̅o̅m̅}̅*̅ a shear stress in the bottom layer, which is induced as explained below by the simulated currents and also the slope of the bottom. The part of shear stress in the bottom layer only induced by water currents is denoted *̅τ̅_̅{̅b̅o̅t̅t̅o̅m̅,̅c̅u̅r̅}̅*̅.

The shear stress in a water layer is the sum of the shear stresses induced in that water layer by the simulated currents. For instance, when the simulated currents include wind-induced currents, river-mouth current and tidal current, the shear stress in the plume layer is computed as follows: $\vec{{τ}_{plume}} = \vec{{τ}_{WIC , plume}} + \vec{{τ}_{river , plume}} + \vec{{τ}_{tidal , plume}}$

Where $\vec{{τ}_{wic , plume}} \left(z\right) = \vec{{τ}_{waves , plume}} \left(z\right) + \vec{{τ}_{OSC , plume}} \left(z\right)$

The depth-average shear stress induced by a water current in a water layer is determined from a shear stress profile according to depth, which is itself determined from a velocity profile of the water currents as a function of water depth in said layer.

Regarding the wind-induced currents, i.e. the wave-induced current and the ocean surface current, each velocity profile in the plume layer is a power law profile, wherein the velocity is maximum at the surface and becomes null at the interface between the plume and the subsurface layers, such that: ${u}_{waves} \left(z\right) = {U}_{max , waves} {\left(\frac{z}{{H}_{p}}\right)}^{m}$ ${u}_{OSC} \left(z\right) = {U}_{max , OSC} {\left(\frac{z}{{H}_{p}}\right)}^{1 / m}$

With m is the power of the velocity profile, here m = 4, and Hₚ is the thickness of the plume layer. The maximum values *U_{max,OSC}* and *U_{max,waves}* at the surface may be determined by computing the integral from the surface to the interface between plume and subsurface layer of each velocity profile as follows: ${U}_{max , OSC} = {U}_{OSC} \frac{1 + m}{m}$ ${U}_{max , waves} = {U}_{waves} \left(1+m\right)$

Where *U_{OSC}* and *U_{waves}* are the mean velocities, over the thickness of the plume layer, of each current, computed in step 330 above.

The shear stress profile according to depth within the plume layer can be computed based on the velocity profile by computing a derivative with respect to depth of the velocity profile of the currents: $τ \left(z\right) = k \frac{\partial u \left(z\right)}{\partial z}$, where k is a calibration constant, for instance equal to 0.1. ${τ}_{waves , plume} \left(z\right) = {τ}_{0 , waves} {\left(\frac{z}{{H}_{p}}\right)}^{m - 1}$ ${τ}_{OSC , plume} \left(z\right) = {τ}_{0 , OSC} {\left(\frac{z}{{H}_{p}}\right)}^{1 / m - 1}$

Where ${τ}_{0 , waves} = {U}_{waves} . \frac{k . m . \left(1+m\right)}{{H}_{p}}$ and ${τ}_{0 , OSC} = {U}_{OSC} . \frac{k . \left(1+m\right)}{{H}_{p} . {m}^{2}}$.

Once the shear stress profile is obtained, computing its average along the vertical axis enables obtaining a mean value of the shear stress induced by the wind-induced currents within the plume layer. Further, the directions of the shear stresses induced by the wave-current and the ocean surface currents, respectively, is the same as the direction of the respective velocity vectors : $\vec{{τ}_{wic , plume}} = \vec{{τ}_{0 , OSC}} . m + \vec{{τ}_{0 , waves}} . \frac{1}{m}$

Regarding computation of a shear stress value incurred by the wind-induced currents within the subsurface and bottom layers, as these currents extend in an opposite direction in the subsurface layer and in the plume layer, it is considered that the velocity of these currents is null at the interface plume/subsurface layer (z=Hₛ=H_{sub}+H_{bot} where H_{bot} is the thickness of the bottom layer and H_{sub} is the thickness of the subsurface layer) and also null on the ground, and the velocity reaches a maximum between those two null points. The velocity profile in the subsurface and bottom layers u_{sub}(z) can thus be written as a sum of velocity profiles occurring within the subsurface and bottom layers, where the velocity profiles are power law profiles of opposite signs with respectively m and 1/m exponents: u_{sub}(z)=u₁(z) + u₂(z) ${u}_{1} \left(z\right) = {U}_{max , 1} {\left(\frac{z}{{H}_{s}}\right)}^{m}$ ${u}_{2} \left(z\right) = {U}_{max , 2} {\left(\frac{z}{{H}_{s}}\right)}^{1 / m}$

Where u₁(z) designates is a first velocity profile of this decomposition, U_{max,1} is the corresponding maximum velocity, u₂(z) designates the second velocity profile of this decomposition, and U_{max,2} is the corresponding maximum velocity.

Computing the integral between the plume/subsurface boundary and the ground of the velocity profile, and considering the null boundary conditions, allows obtaining the two constant parameters U_{max,1} and U_{max,2}: ${U}_{max , 2} = - {U}_{max , 1} = {U}_{wic , sub} \frac{1 + m}{m - 1}$

Where U_{wic,sub} is the mean velocity of return currents in the subsurface layer computed above. The shear stress profile according to depth within the subsurface and bottom layers of the return currents can be computed by computing the derivative of the current velocity profile in the subsurface layer: $\vec{{τ}_{sub}} \left(z\right) = \vec{{τ}_{1}} \left(z\right) + \vec{{τ}_{2}} \left(z\right) = \vec{{τ}_{0 , 1}} . {\left(\frac{z}{{H}_{s}}\right)}^{m - 1} + \vec{{τ}_{0 , 2}} . {\left(\frac{z}{{H}_{s}}\right)}^{1 / m - 1}$

With $\vec{{τ}_{0 , 1}} = \vec{{U}_{sub}} . \frac{k . m . \left(1+m\right)}{{H}_{s} \left(m-1\right)}$ and $\vec{{τ}_{0 , 2}} = - \vec{{U}_{sub}} . \frac{k . \left(1+m\right)}{{H}_{s} \left(m-1\right) . m}$.

Once the shear stress profile is obtained, the mean shear stress induced by return currents within the subsurface layer, i.e., from the interface between the bottom and subsurface layers (z=H_{bot}) and the interface between the subsurface and plume layers (z=Hₛ), can be computed as: $\vec{{τ}_{wic , subsurface}} = \left\{\begin{matrix}\frac{1}{1 - {z}_{b}} \left(\frac{\vec{{τ}_{0 , 1}}}{m}\left(1-2{a}^{m}+{z}_{b}^{m}\right)+m.\vec{{τ}_{0 , 2}}\left(1-2{a}^{\frac{1}{m}}+{z}_{b}^{\frac{1}{m}}\right)\right) if a \geq {z}_{b} \\ \frac{1}{1 - {z}_{b}} \left(\frac{\vec{{τ}_{0 , 1}}}{m}\left(1-{z}_{b}^{m}\right)+m.\vec{{τ}_{0 , 2}}\left(1-{z}_{b}^{\frac{1}{m}}\right)\right) if a \leq {z}_{b}\end{matrix}\right.$

With ${z}_{b} = \frac{{H}_{bot}}{{H}_{s}}$ and $a = {\left(\frac{1}{m}\right)}^{\frac{m}{{m}^{2} - 1}}$.

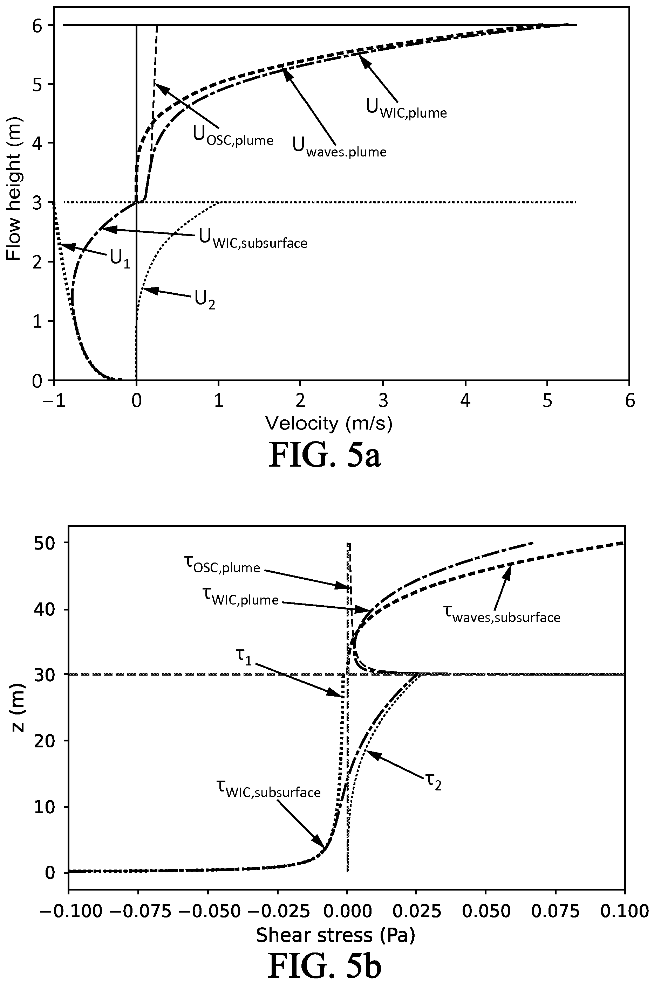

The velocity profiles of the wind-induced currents within the plume and subsurface layers are shown in figure 5a, and the shear stress profiles induced by said currents within the same water layers are shown in figure 5b.

As the bottom layer corresponds to the boundary limit of the subsurface layer's flow, a mean shear stress value in said layer is computed by the mean of the shear stress profile between the ground (z=0) and the top of the bottom layer, i.e. the interface between the bottom and subsurface layers (z=H_{bot}), and is equal to (considering only return currents of wind-induced currents): $\vec{{τ}_{wic , bottom}} = \left\{\begin{matrix}\frac{1}{{z}_{d}} \left(\frac{\vec{{τ}_{0 , 1}}}{m}{z}_{b}^{m}+m.\vec{{τ}_{0 , 2}}{z}_{b}^{\frac{1}{m}}\right) if a \geq {z}_{b} \\ \frac{1}{{z}_{b}} \left(\frac{\vec{{τ}_{0 , 1}}}{m}\left({z}_{b}^{m}-2{a}^{m}\right)+m.\vec{{τ}_{0 , 2}}\left({z}_{b}^{\frac{1}{m}}-2{a}^{1 / m}\right)\right) if a \leq {z}_{b}\end{matrix}\right.$

Regarding the tidal current and river-mouth current, their velocity profile according to water depth is also assumed to be a power function with a 1/m exponent, but said velocity profile extends over all the water depth from surface to bottom: ${u}_{river} \left(z\right) = {U}_{max , river} {\left(\frac{z}{WD}\right)}^{1 / m}$ ${u}_{tidal} \left(z\right) = {U}_{max , tidal} {\left(\frac{z}{WD}\right)}^{1 / m}$

The maximum values *U_{max,river}* and *U*_{*max*,tidal} at the surface may be determined by computing the integral from the surface to the interface between plume and subsurface layer of each velocity profile: ${U}_{max , river} = {U}_{river} \frac{1 + m}{m}$ ${U}_{max , tidal} = {U}_{tidal} \frac{1 + m}{m}$

Uᵣᵢᵥₑᵣ is equal to *u̅* defined in WO 2020/229865. U_{tidal} corresponds to the value of velocity *E_{tc,plume}* of the tidal current defined in WO 2020/229866.

The shear stress profile is then a derivative of the velocity profile according to z: $\vec{{τ}_{river}} \left(z\right) = \vec{{τ}_{0 , river}} {\left(\frac{z}{WD}\right)}^{1 / m - 1}$ $\vec{{τ}_{tidal}} \left(z\right) = \vec{{τ}_{0 , tidal}} {\left(\frac{z}{WD}\right)}^{1 / m - 1}$

Where $\vec{{τ}_{0 , river}} = \vec{{U}_{river}} . \frac{k . \left(1+m\right)}{WD . {m}^{2}}$ and $\vec{{τ}_{0 , tidal}} = \vec{{U}_{tidal}} ⋅ \frac{k . \left(1+m\right)}{WD . {m}^{2}}$

The shear stress vector in each water layer can then be inferred by this profile by integrating the shear stress profile between the limits of each current, and the direction of the vector is provided by the direction of the velocity vector of the corresponding current.

Finally, the total shear stress vectors in the plume and in the subsurface layers are the sums of the shear stress vectors resulting from each simulated current in the corresponding layer.

Additionally, a specificity of the bottom layer is that the sediments are not only submitted to a shear stress induced by the flowing currents, but also to gravity, leading to take into account a gravity component of the shear stress within the bottom layer. This component depends on the topographic slope of the ground surface but also on proprieties of the sediments. Accordingly:
- if the slope is null, the shear stress induced by the gravity is null,
- the value of the shear stress induced by gravity on the particle is equal to a deposition shear stress threshold when the current velocity in the subsurface layer is null and the topographic slope of the ground surface is superior or equal to an avalanche angle determined for the particle, and
- the direction of the shear stress induced by gravity on the particle is parallel to the direction of the downward topographic slope of the water bottom.

The gravity-induced shear stress applied to a particle of granulometry gr is computed as follows: $\vec{{τ}_{slope . gr}} = \frac{1}{e - 1} \left(exp\left(\frac{α}{{α}_{cr} \left(gr\right)}\right)-1\right) . {τ}_{Cr} . \vec{slope}$

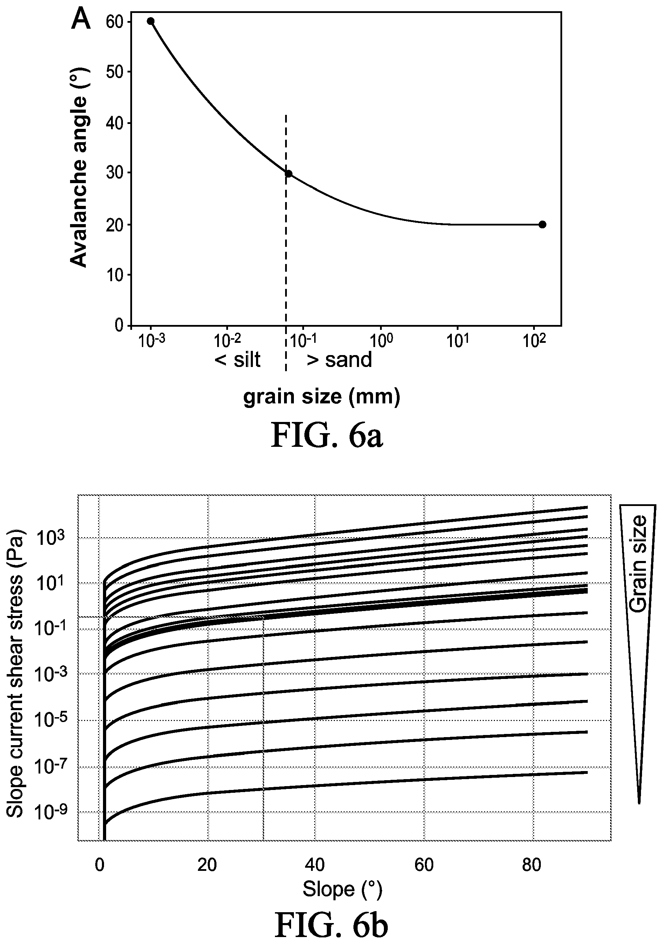

Where α is the topographic slope, α_{Cr} is the avalanche angle, i.e. the critical slope of the particles, depending on their granulometry as shown in figure 6a, *τ_{Cr}* is the critical shear stress of deposition of the particles, and *slope* is the direction of the descending slope. Figure 6b shows the gravity-induced shear stress as a function of granulometry.

The total shear stress within the bottom layer applied to particle of granulometry gr is therefore equal to: $\vec{{τ}_{bottom}} = \vec{{τ}_{bottom , Cur}} + \vec{{τ}_{slope , gr}}$

Back to figure 2, once the shear stress has been computed, the method further comprises a step 500 of introducing at least one particle of sediments in at least one cell of the geological gridded model. The number of particles introduced at step 500, the type of elements and their granulometric class, depend on the supply or production model defined at setup step 90.

The location, within the model, where the particles are introduced depends on the source of the particles. For instance, regarding clastic supply processes such as river mouth or volcano, the location of the source of particle is set during the setup step. Regarding in-situ production of carbonates, said production may occur in any cell where the conditions enabling the production are met. For instance, if a production function is associated with conditions on water depth, the production may occur only in the cells of the model in which the water depth satisfies the conditions.

The depth at which the particles are introduced also depend from the process they originate from and the granulometric class of the particle. Accordingly, particles originating from:
- mineral sources causing deposit of travertine, or
- in-situ production of carbonates,
are introduced at the water bottom, immediately deposited, and may be remobilized when stormy events are simulated, as explained in greater details below. On the other hand, particles originating from a river mouth can be introduced in various water layers as detailed in WO2020/229865.

The method then comprises a step 600 of determining a transport of the particles of siliciclastic sediments introduced in the geological gridded model, based on the water-currents induced shear stress. The transport may comprise displacing a particle from a cell to a neighboring cell and/or depositing the particle.

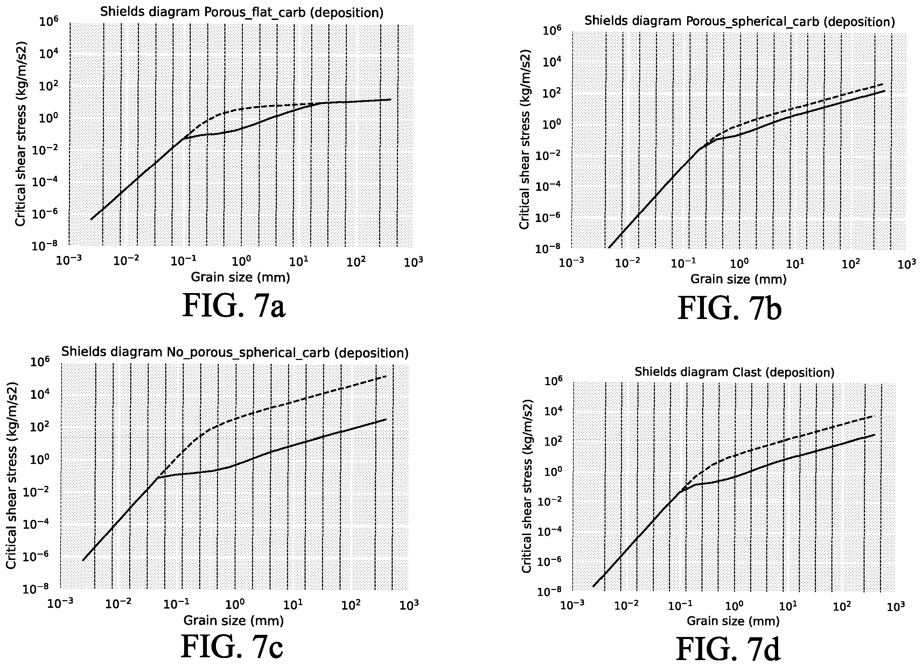

Figures 7a to 7d represent Shields diagram for deposition of particles, expressing the shear stress values for transport and deposition of sediments according to their grain diameter. Figure 7a relates to porous flat carbonates, figure 7b relates to porous spherical carbonates, figure 7c relates to non-porous spherical carbonates, and figure 7d relates to clast. The transport of a particle may be either a transport by traction or a transport by suspension. In figures 7a to 7d, the area under the solid line corresponds to a zone where the particles are not transported, the area between the solid line and the dotted line corresponds to a zone where the particles are transported by traction, and the area above the dotted line corresponds to a zone where the particles are transported by suspension. The solid line thus corresponds to a traction shear stress threshold, and the dotted line corresponds to a suspension shear stress threshold. The determination of the transport mode of a particle depends on the shear stress induced on the particle at the water level where the particle is located and on the shear stress thresholds which depend on the particle, and which are represented by the lines of the Shields diagram.

Accordingly, the step of transporting and/or depositing a particle is performed as follows:
- If the particle is located in the plume or subsurface layer:
   ∘ if the shear stress value in the water layer in which the particle is located is higher than the suspension shear stress threshold, the particle is transported to an adjacent cell, said adjacent cell being determined based on the determined direction shear stress, and the particle remains within the same water layer,
   ∘ if the shear stress induced on the particle is lower than the suspension shear stress threshold, the particle is transported downwards, i.e. to the subsurface layer if the particle is originally in the plume layer, or in the bottom layer if the particle is originally in the subsurface layer, while remaining within the same cell,
- if the particle is located in the bottom layer, and
   ∘ if the shear stress induced on the particle is higher than a traction shear stress threshold, the particle is transported to an adjacent cell, said adjacent cell being determined based on the determined direction of the shear stress within the bottom layer, and remains within the bottom layer,
   ∘ if the shear stress induced on the particle is lower than the traction shear stress threshold, the particle is deposited on the ground surface.

In embodiments, the transport step 600 may comprise a preliminary substep 601 of modelling aggregation of particles by flocculation. Flocculation is a process by which fine-grain particles are electrically charged, which lead them to being gathered together due to Van des Waals forces. If flocculation is modelled, then preferably every implementation of the transport step includes said preliminary substep of modelling flocculation.

Accordingly, a fraction of flocculated particles is computed based on a plurality of controlling factors including at least the particle size and the current-induced shear stress occurring within the considered layer of water. The controlling factors preferably also comprise salinity and the concentration of suspended sediments, the latter being computed in each cell as V_{particle}/V_{water} where V_{particle} is the total volume of particles present in the cell (resulting from introduction and/or transport of particles into the cell) and V_{water} is the volume of water in the cell, which is computed from the side length of the cell and the water depth in the cell..

In embodiments, the fraction of flocculated particles may be computed based on the following function: ${F}_{floc} = T . \left({F}_{floc , 0}+\left(1-{F}_{floc , 0}\right).{\prod }_{controlling factors} {F}_{i}\right)$

Where F_{floc,O} is a background flocculation fraction, i.e. a proportion of particles which flocculate no matter the values of the controlling factors. It is a constant value which may be user-defined, and for instance set to 0. Fi is a controlling factor function expressing a flocculation fraction in % according to a value of the corresponding controlling factor.

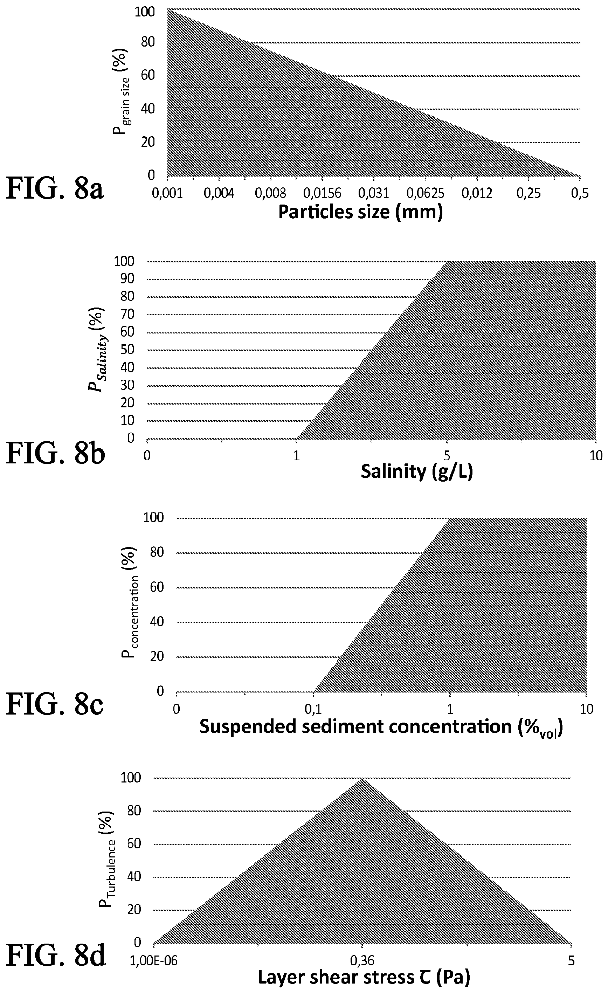

With reference to figures 8a to 8d are shown exemplary controlling factors functions. As shown in fig. 8a, the fraction of flocculated particles decreases with the size of the particles, but increases with salinity (fig. 8b) and with the concentration of suspended sediments (fig. 8c). The fraction of flocculated particles also increases with the current induced layer shear stress until the latter reaches a threshold value (0.36 in figure 8d), and then decreases with the shear stress value. The shear stress value is here used as an indicator of the turbulence of the water: a turbulence increase brings together the particles and fosters contact between them; but when turbulence exceeds a threshold the particles no longer aggregate one another. Flocculation is performed by aggregating the particles two by two starting from the finer ones, until the amount of aggregated particles reaches the fraction F_{floc}. For a considered particle, the particle that is aggregated to it is randomly cast according to the granulometric distribution of the particles. The result is a flocculated particle which size is the sum of the sizes of the two aggregated particles.

On figure 9 is shown an example of initial distribution of introduced particles at step 500 and the result of the flocculation process on said distribution.

Step 600 of transporting and/or depositing particles is iterated until all particles are deposited or have exiting the model.

In order for the modelling method to include simulation of stormy events, the method further comprises a step 700 of modelling remobilization of a fraction of the particles deposited at step 600, following occurrence of stormy events. During implementation of step 700, only a fraction of the particles deposited during the same computation layer, corresponding to the same time-period, are remobilized. The particles deposited during a previous computation layer corresponding to a previous time-period are not remobilized.

Modelling remobilization 700 of a fraction of deposited particles comprises determining 710 a shear stress induced on the deposited particles during a stormy event and determining a fraction of the deposited particles which is remobilized, as well as the water current 720 in which the particles are remobilized particles.

Determining the shear stress induced on the deposited particles during a stormy event 710 involves determining a velocity and a direction of at least one wind-induced current occurring within the modelled area during a stormy event. This step can be performed according to the description of step 300 above, except that the celerity vector of the wind is the vector *̅u̅_̅{̅w̅,̅s̅t̅o̅r̅m̅}̅*̅ assigned to stormy event, which is different from the celerity vector of the wind *̅u̅_̅{̅w̅}̅*̅ in fair weather conditions, i.e. the speed is greater and the direction may vary. When other currents are modelled during step 400, the same currents may also be modelled for stormy events, and a resulting current may be computed from the sum of modelled currents.

A shear stress value and direction imparted by the currents on the deposited particles, i.e. a shear stress value imparted by the currents in the bottom layer of the cells, is then computed in the same manner as step 400 disclosed above.

The fraction of remobilized particles of a given grain size gr is then computed as follows: ${Frac}_{remobilized}^{gr} = \left\{\begin{matrix}0 & if {τ}_{Bottom} \leq {τ}_{threshold , min}^{gr} \\ {t}_{f} ⋅ \frac{{τ}_{Bottom} - {τ}_{threshold , min}^{gr}}{{τ}_{threshold , max}^{gr} - {τ}_{threshold , min}^{gr}} & if {τ}_{threshold , min}^{gr} \leq {τ}_{bottom} \leq {τ}_{threshold , max}^{gr} \\ {t}_{f} & if {τ}_{Bottom} \geq {τ}_{threshold , max}^{gr}\end{matrix}\right.$

Where ${τ}_{threshold , min}^{gr}$ and ${τ}_{threshold , max}^{gr}$ are shear stress thresholds of the deposited particles which may be defined by the user. t_{f} is a time factor defined as: ${t}_{f} = \left\{\begin{matrix}\frac{{t}_{storm}}{{t}_{max}} if {t}_{storm} \leq {t}_{max} \\ 1 if {t}_{storm} > {t}_{max}\end{matrix}\right.$

And tₘₐₓ is a parameter from which the time factor t_{f} is equal to 1. tₘₐₓ can for instance be set at 10 days / year.

If the shear stress induced by the currents in the bottom layer is lower than the minimum shear stress threshold value ${τ}_{threshold , min}^{gr}$, then no particles are remobilized.

When particles are indeed remobilized (*Frac_{remobilized}* ≠ 0), the water layer in which the particles are remobilized is determined 720 based on the shear stress value induced by the currents in at least the bottom layer - possibly in both the bottom and the subsurface layers, and possibly in each layer - and at least one characteristic shear stress value of the considered particle:
- the fraction of remobilized particle is integrally remobilized in the bottom layer if the shear stress value induced by the currents in the bottom layer is greater than the critical motion shear stress value of the particles, but if the shear stress value induced by the currents in the subsurface layer is lower than a critical suspension shear stress value of the particles: *if τ_{BOTTOM}* > *τ_{Cr,motion} and τ_{SUBSURFACE}* ≤ *τ_{Cr,suspension} then* 100% *of Frac_{remob} is remobilized in bottom layer*
- if the shear stress value induced by the currents in the subsurface layer is greater than the critical suspension shear stress value of the particles, and the shear stress value induced by the currents in the plume layer is lower than said critical suspension shear stress value, a part of the remobilized fraction of particles is remobilized in the subsurface layer and the rest is remobilized in the bottom layer:
   *if τ_{BOTTOM}* > *τ_{Cr,motion} and τ_{SUBSURFACE}* > *τ_{Cr,suspension} and τ_{PLUME}* ≤ *τ_{Cr,suspension} then a suspended fraction Fₛᵤₛₚ is remobilized in the subsurface layer*
- if the shear stress values induced by the currents in both the subsurface and the plume layer are greater than the critical suspension shear stress value of the particles, then part of the remobilized suspended fraction of particles is remobilized in the plume layer and the rest is remobilized in the subsurface layer:
   *if τ_{BOTTOM}* > *τ_{Cr,motion} and τ_{SUBSURFACE}* > *τ_{Cr,suspension} and τ_{PLume}* > *τ_{Cr,suspension} then a fraction Fₚₗᵤₘₑ of the suspended fraction Fₛᵤₛₚ is remobilized in the plume layer and* 1 *- Fₚₗᵤₘₑ is remobilised in the subsurface layer*

In the second situation recited above, the fraction of suspended particles may be computed as: ${F}_{susp} = \left\{\begin{matrix}\frac{{τ}_{SUBSURFACE} - {τ}_{Cr , suspension}}{{τ}_{SUBSURFACE} - {τ}_{Cr , motion}} & if {τ}_{Cr , suspension} \geq {τ}_{Cr , motion} \\ \frac{{τ}_{SUBSURFACE} - {τ}_{Cr , suspension}}{{τ}_{Cr , motion} - {τ}_{Cr , suspension}} & if {τ}_{Cr , suspension} < {τ}_{Cr , motion}\end{matrix}\right.$

In the third situation recited above, part of the fraction of suspended particles is remobilized in the plume layer and may be computed as: ${F}_{plume} = \frac{{H}_{plume}}{{H}_{plume} + {H}_{sub}} . {F}_{susp}$

The remainder is remobilized in the subsurface layer: ${F}_{subsurface} = 1 - {F}_{plume}$

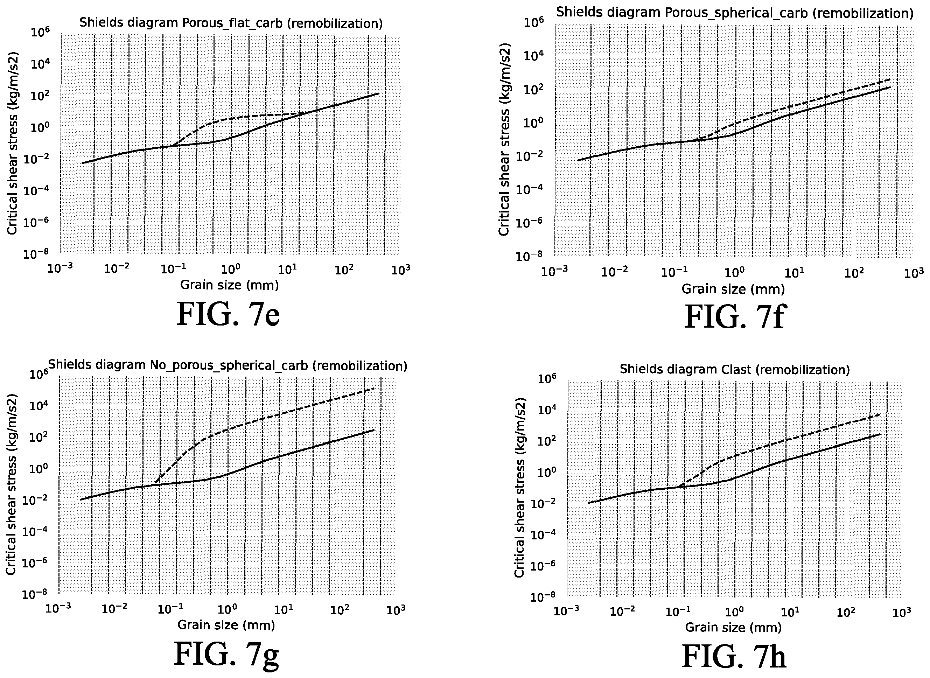

With reference to figures 7e to 7h, representing Shields diagrams expressing the shear stress values for remobilization of clastic and carbonates sediments according to their grain diameter, the critical motion shear stress depends on the grain diameter of the particle and can be determined using said Shields diagram. Figure 7e relates to porous flat carbonates, figure 7f relates to porous spherical carbonates, figure 7g relates to non-porous spherical carbonates and figure 7h relates to clast. In these figures, the zone below the solid line is a zone where the particles are not remobilized, the zone between the solid line and the dotted line is a zone where the particles are remobilized by traction (i.e. in the bottom layer) and the zone above the dotted line corresponds to a remobilization by suspension. The solid line thus corresponds to a critical motion shear stress and the dotted line corresponds to a critical suspension shear stress. It should be underlined that for fine grains, for instance silt, fine sand or clay particles, there is no distinction between the critical suspension shear stress and the critical motion shear stress. As a consequence, these particles are either not remobilized or remobilized. If remobilized, these particles can be transported in the bottom layer if the shear stress value within the subsurface layer is lower than the critical suspension shear stress. Thus the equation for computing Fₛᵤₛₚ above is not applicable.

Last, for each layer, the volume of remobilized sediments during stormy events can be computed from the fraction of sediments remobilized in each layer (*F_{layer}*) multiplied by the volume of deposited particles in fair weather conditions *V_{sed,depo,fairweather}* (step 600): ${V}_{sed , remobilized , layer} = {F}_{layer} . {V}_{sed , depo , fairweather}$

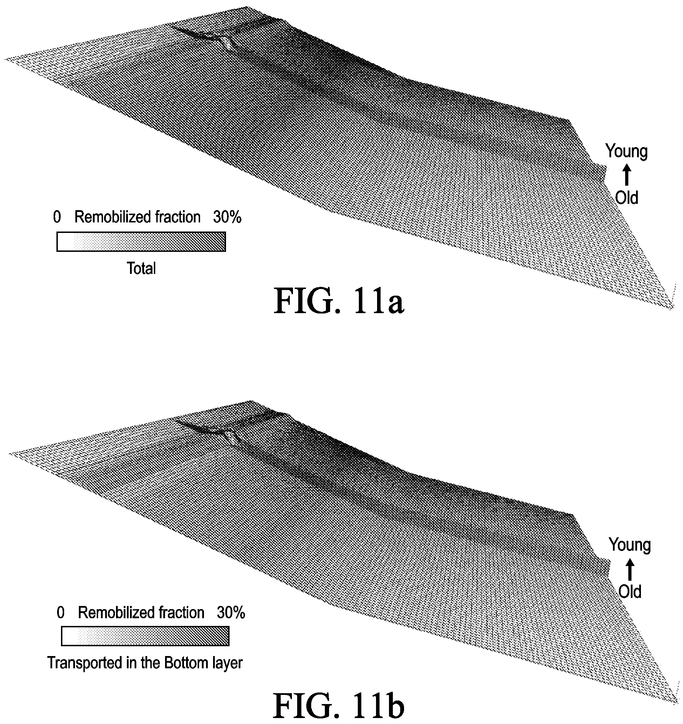

An illustration of the remobilization is shown in figures 11a and 11b. As in figure 1, these figures display the geological gridded model in which a first time-layer is represented and a cut section of the stack of superposed time-layers deposited on the first time-layer is also displayed. Unlike figure 1, the grey level of the cells does not represent the water depth of the cells but, in figure 11a, the fraction of particles of the cell which are remobilized during computation of step 700 of the corresponding time layer, and, in figure 11b, the fraction of remobilized particles which are transported in the bottom layer. One can notice here that the impact of the water depth is rendered in the remobilization process, since the increasing water depth toward the right side of the grid yields a decrease in the shear stress in the bottom layer thus a decrease in the remobilized fraction.

As schematically shown in figure 2, the step 700 of remobilizing particles is followed by implementation of a step 600' of modelling transport and/or deposition of the remobilized particle, which may also include a flocculation substep 601. Said step 600 is iterated until all particles are deposited or have exited the model.

Implementation of a step 600' of modelling transport and/or deposition of particles after remobilization is performed the same way as a step 600 implemented prior to remobilization, except that the shear stresses computed for the modelled currents are computed in stormy conditions, i.e. taking *̅u̅_̅{̅w̅i̅n̅d̅,̅s̅t̅o̅r̅m̅}̅*̅ as the wind speed vector for computing the velocity and shear stress values corresponding to the wind-induced currents.

During a step 800, the topography of the geological model of the area is updated to take into account the sediments deposited during the computational layer, i.e. an additional time layer is generated, which thickness is determined based on the volume of deposited sediments during the period of time corresponding to the computational layer. Step 800 may also comprise updating topography according to eustatism and subsidence, i.e. respectively the reference water level and the ground level may be changed by updating the position along z of each cell and the water depth of each cell.

At the end of the simulation, the modified model of the sedimentary area represents the evolved state of a sedimentary basin. This model is used to extract data, such as for instance a log of sediments, to be compared with observed data acquired from a well.

## Claims

1. A computer-implemented method of modelling the sedimentary deposition within an immersed area subject to stormy meteorological events, comprising:
- a setup comprising defining a geological gridded model of the immersed area, a
- period of time during which sedimentary deposition is modelled, a reference water level, at least one supply process of particles to be introduced within the model, at least one water current type occurring within the immersed area and a duration of stormy conditions within the period of time, and
- simulating the evolution of the geological gridded model over the period of time, comprising:
∘ assigning a water depth to a plurality of cells,
∘ introducing at least one particle in at least one cell of the geological gridded model,
∘ determining (600) a transport of at least one introduced particle induced by the water current in fairweather conditions, wherein the transport of a particle comprises displacing the particle or depositing the particle on water bottom,
∘ modelling remobilization (700) of a fraction of the deposited particles following occurrence of stormy conditions,
∘ determining (600') a transport of the remobilized fraction of particles induced by the water current in stormy conditions, wherein the transport of a particle comprises displacing the particle or depositing the particle on water bottom and **characterized in that** the method comprises:
∘ updating (800) a topography of the geological gridded model of the area according to the transport of the particles,
and wherein the steps of determining a transport of the introduced particles and remobilized particles are repeated until all introduced particles are deposited or have exited the gridded model, and wherein the method also comprises extracting data from the updated model to be compared with observed data acquired from a well.

2. The method according to claim 1, wherein determining the transport (600, 600') of a particle comprises:
- determining a direction and velocity of the at least one water current within the immersed area,
- determining, from the direction and velocity of the water current, a direction and intensity of a shear stress induced by the water current, and
- determining that the particle is transported or deposited based on the determined direction and intensity of the shear stress, a granulometry and sediment type of the particle.

3. The method according to any of the preceding claims, wherein modelling remobilization of a fraction of the deposited particles comprises determining the fraction of the deposited particles which is remobilized during a stormy event.

4. The method according to claim 3, wherein the setup further comprises defining a wind speed associated to stormy conditions, and determining the fraction of the deposited particles which is remobilized during a stormy event comprises:
- determining a velocity of at least one water current induced by the wind within the immersed area during a stormy event,
- Determining, from the velocity of the water current, a value of a shear stress induced on the deposited particles by the wind-induced water current and,
- Determining the fraction of the deposited particles which is remobilized during the stormy event based on said shear stress value.

5. The method according to claim 4, further comprising a preliminary step of defining water layers corresponding to respective water depths ranges extending between the surface and the bottom of the immersed area, comprising:
- A bottom layer, located at water bottom,
- A plume layer, located at water surface, and
- A subsurface layer, extending between the bottom and the plume layer,
and modelling remobilization of a fraction of the deposited particles comprises determining a fraction of particles remobilized in each water layer.

6. The method according to claim 5, wherein determining a velocity of at least one water current induced by the wind within the immersed area under stormy conditions comprises:
- Determining the velocity of a wind-induced current occurring in the plume layer based on parameters inferred from the wind speed, and
- Determining the velocity of a return current occurring in the subsurface layer and resulting from the wind-induced current occurring in the plume layer.

7. The method according to claim 6, wherein determining a velocity of a wind-induced current occurring in the plume layer comprises determining a velocity of one of an ocean surface current caused by an Ekman vortex and a wave-induced current.

8. The method according to any of claims 5 to 7, wherein determining a fraction of particles remobilized in each water layer is based on the shear stress value induced on the particles in the bottom layer, a shear stress value induced on the particles in the considered water layer and at least one shear stress threshold value.

9. The method according to claim 8, wherein all the remobilized particles are remobilized in the bottom layer if:
- the shear stress value in the bottom layer is higher than a motion shear stress threshold value of the particles, and
- the shear stress value in the subsurface layer is lower than a critical suspension shear stress value of the particles.

10. The method according to claim 8 or 9, wherein a fraction of remobilized particles is suspended in the subsurface layer if:
- the shear stress value in the bottom layer is higher than a motion shear stress threshold value of the particles, and
- the shear stress value in the subsurface layer is greater than a critical suspension shear stress value of the particles.

11. The method according to any of claims 8 to 10, wherein a fraction of the remobilized particles is suspended in the plume and subsurface layer:
- the shear stress value in the bottom layer is higher than a motion shear stress threshold value of the particles,
- a shear stress value in the subsurface layer is higher than a suspension shear stress threshold value of the particles, and
- a shear stress value in the plume layer is higher than the suspension shear stress threshold value of the particles.

12. A computer program product comprising code instructions for implementing the method according to any of the preceding claims, when it is executed by a processor.

13. A non-transitory computer readable storage medium, having stored thereon a computer program comprising program instructions, the computer program being loadable into a processor and adapted to cause the processor to carry out, when the computer program is run by the processor, the method according to any of the claims 1 to 11.

## Patentansprüche

1. Computerimplementiertes Verfahren zur Modellierung der Sedimentablagerung in einem eingetauchten Bereich, der stürmischen Wetterereignissen ausgesetzt ist, umfassend:
- ein Setup, umfassend das Definieren eines geologischen Gittermodells des eingetauchten Bereichs, eines
- Zeitraums, während dessen die Sedimentablagerung modelliert wird, eines Referenzwasserstands, mindestens eines Zufuhrprozesses von in das Modell einzuführenden Partikeln, mindestens einer Art von Wasserströmung, die in dem eingetauchten Bereich auftritt, und einer Dauer von Sturmbedingungen innerhalb des Zeitraums, und
- Simulieren der Entwicklung des geologischen Gittermodells über den Zeitraum, umfassend:
- Zuweisen einer Wassertiefe zu einer Vielzahl von Zellen,
- Einführen von mindestens einem Partikel in mindestens eine Zelle des geologischen Gittermodells,
- Bestimmen (600) eines Transports von mindestens einem eingeführten Partikel, der durch die Wasserströmung unter Schönwetterbedingungen induziert wird, wobei der Transport eines Partikels das Verschieben des Partikels oder das Ablagern des Partikels auf dem Wassergrund umfasst,
- Modellieren der Remobilisierung (700) eines Anteils der abgelagerten Partikel nach dem Auftreten von Sturmbedingungen,
- Bestimmen (600') eines Transports des remobilisierten Anteils von Partikeln, der durch die Wasserströmung unter Sturmbedingungen induziert wird, wobei der Transport eines Partikels das Verschieben des Partikels oder das Ablagern des Partikels auf dem Wassergrund umfasst und 2 **dadurch gekennzeichnet, dass** das Verfahren umfasst: 2
- Aktualisieren (800) einer Topographie des geologischen Gittermodells des Bereichs gemäß dem Transport der Partikel,
und wobei die Schritte des Bestimmens eines Transports der eingeführten Partikel und der remobilisierten Partikel wiederholt werden, bis alle eingeführten Partikel abgelagert sind oder das Gittermodell verlassen haben, und wobei das Verfahren auch das Extrahieren von Daten aus dem aktualisierten Modell zum Vergleich mit beobachteten Daten, die aus einem Bohrloch gewonnen wurden, umfasst.

2. Verfahren nach Anspruch 1, wobei das Bestimmen des Transports (600, 600') eines Partikels umfasst:
- Bestimmen einer Richtung und Geschwindigkeit der mindestens einen Wasserströmung in dem eingetauchten Bereich,
- Bestimmen, aus der Richtung und Geschwindigkeit der Wasserströmung, einer Richtung und Intensität einer durch die Wasserströmung induzierten Schubspannung, und
- Bestimmen, dass das Partikel transportiert oder abgelagert wird, basierend auf der bestimmten Richtung und Intensität der Schubspannung, einer Granulometrie und einem Sedimenttyp des Partikels.

3. Verfahren nach einem der vorhergehenden Ansprüche, wobei die Modellierung der Remobilisierung eines Anteils der abgelagerten Partikel das Bestimmen des Anteils der abgelagerten Partikel umfasst, der während eines Sturmereignisses remobilisiert wird.

4. Verfahren nach Anspruch 3, wobei das Setup ferner das Definieren einer mit Sturmbedingungen verbundenen Windgeschwindigkeit umfasst, und das Bestimmen des Anteils der abgelagerten Partikel, der während eines Sturmereignisses remobilisiert wird, umfasst:
- Bestimmen einer Geschwindigkeit von mindestens einer durch den Wind induzierten Wasserströmung innerhalb des eingetauchten Bereichs während eines Sturmereignisses,
- Bestimmen, aus der Geschwindigkeit der Wasserströmung, eines Wertes einer Schubspannung, die auf die abgelagerten Partikel durch die windinduzierte Wasserströmung induziert wird, und
- Bestimmen des Anteils der abgelagerten Partikel, der während des Sturmereignisses remobilisiert wird, basierend auf dem genannten Schubspannungswert.

5. Verfahren nach Anspruch 4, ferner umfassend einen vorbereitenden Schritt des Definierens von Wasserschichten, die jeweiligen Wassertiefenbereichen entsprechen, die sich zwischen der Oberfläche und dem Grund des eingetauchten Bereichs erstrecken, umfassend:
- eine Bodenschicht, die sich am Wassergrund befindet,
- eine Fahnenschicht, die sich an der Wasseroberfläche befindet, und
- eine Untergrundschicht, die sich zwischen dem Grund und der Fahnenschicht erstreckt,
und die Modellierung der Remobilisierung eines Anteils der abgelagerten Partikel umfasst das Bestimmen eines Anteils von in jeder Wasserschicht remobilisierten Partikeln.

6. Verfahren nach Anspruch 5, wobei das Bestimmen einer Geschwindigkeit von mindestens einer durch den Wind induzierten Wasserströmung innerhalb des eingetauchten Bereichs unter Sturmbedingungen umfasst:
- Bestimmen der Geschwindigkeit einer windinduzierten Strömung, die in der Fahnenschicht auftritt, basierend auf Parametern, die aus der Windgeschwindigkeit abgeleitet werden, und
- Bestimmen der Geschwindigkeit einer Rückströmung, die in der Untergrundschicht auftritt und aus der in der Fahnenschicht auftretenden windinduzierten Strömung resultiert.

7. Verfahren nach Anspruch 6, wobei das Bestimmen einer Geschwindigkeit einer in der Fahnenschicht auftretenden windinduzierten Strömung das Bestimmen einer Geschwindigkeit von einer von einer Meeresoberflächenströmung, die durch einen Ekman-Wirbel verursacht wird, und einer welleninduzierten Strömung umfasst.

8. Verfahren nach einem der Ansprüche 5 bis 7, wobei das Bestimmen eines Anteils von in jeder Wasserschicht remobilisierten Partikeln auf dem auf die Partikel in der Bodenschicht induzierten Schubspannungswert, einem auf die Partikel in der betrachteten Wasserschicht induzierten Schubspannungswert und mindestens einem Schubspannungsschwellenwert basiert.

9. Verfahren nach Anspruch 8, wobei alle remobilisierten Partikel in der Bodenschicht remobilisiert werden, wenn:
- der Schubspannungswert in der Bodenschicht höher ist als ein Bewegungsschubspannungsschwellenwert der Partikel, und
- der Schubspannungswert in der Untergrundschicht niedriger ist als ein kritischer Suspensionsschubspannungsschwellenwert der Partikel.

10. Verfahren nach Anspruch 8 oder 9, wobei ein Anteil remobilisierter Partikel in der Untergrundschicht suspendiert wird, wenn:
- der Schubspannungswert in der Bodenschicht höher ist als ein Bewegungsschubspannungsschwellenwert der Partikel, und
- der Schubspannungswert in der Untergrundschicht größer ist als ein kritischer Suspensionsschubspannungsschwellenwert der Partikel.

11. Verfahren nach einem der Ansprüche 8 bis 10, wobei ein Anteil der remobilisierten Partikel in der Fahnenschicht und der Untergrundschicht suspendiert wird:
- der Schubspannungswert in der Bodenschicht höher ist als ein Bewegungsschubspannungsschwellenwert der Partikel,
- ein Schubspannungswert in der Untergrundschicht höher ist als ein Suspensionsschubspannungsschwellenwert der Partikel, und
- ein Schubspannungswert in der Fahnenschicht höher ist als der Suspensionsschubspannungsschwellenwert der Partikel.

12. Computerprogrammprodukt, umfassend Codeanweisungen zur Implementierung des Verfahrens nach einem der vorhergehenden Ansprüche, wenn es von einem Prozessor ausgeführt wird.

13. Nicht-flüchtiges computerlesbares Speichermedium, auf dem ein Computerprogramm gespeichert ist, das Programmanweisungen umfasst, wobei das Computerprogramm in einen Prozessor ladbar und dazu eingerichtet ist, den Prozessor zu veranlassen, das Verfahren nach einem der Ansprüche 1 bis 11 auszuführen, wenn das Computerprogramm von dem Prozessor ausgeführt wird.

## Revendications

1. Procédé mis en œuvre par ordinateur de modélisation du dépôt sédimentaire au sein d'une zone immergée soumise à des événements météorologiques de tempête, comprenant :
- une configuration comprenant la définition d'un modèle maillé géologique de la zone immergée, une période de temps pendant laquelle le dépôt sédimentaire est modélisé, un niveau d'eau de référence, au moins un processus d'apport de particules à introduire au sein du modèle, au moins un type de courant d'eau survenant au sein de la zone immergée et une durée de conditions de tempête au sein de la période de temps, et
- la simulation de l'évolution du modèle maillé géologique sur la période de temps, comprenant :
- l'attribution d'une profondeur d'eau à une pluralité de cellules,
- l'introduction d'au moins une particule dans au moins une cellule du modèle maillé géologique,
- la détermination (600) d'un transport d'au moins une particule introduite induit par le courant d'eau dans des conditions de beau temps, dans lequel le transport d'une particule comprend le déplacement de la particule ou le dépôt de la particule sur le fond de l'eau,
- la modélisation de la remobilisation (700) d'une fraction des particules déposées suite à la survenance de conditions de tempête,
- la détermination (600') d'un transport de la fraction remobilisée de particules induit par le courant d'eau dans des conditions de tempête, dans lequel le transport d'une particule comprend le déplacement de la particule ou le dépôt de la particule sur le fond de l'eau et **caractérisé en ce que** le procédé comprend :
- la mise à jour (800) d'une topographie du modèle maillé géologique de la zone conformément au transport des particules,
et dans lequel les étapes de détermination d'un transport des particules introduites et des particules remobilisées sont répétées jusqu'à ce que toutes les particules introduites soient déposées ou aient quitté le modèle maillé, et dans lequel le procédé comprend également l'extraction de données à partir du modèle mis à jour pour les comparer avec des données observées acquises à partir d'un puits.

2. Procédé selon la revendication 1, dans lequel la détermination du transport (600, 600') d'une particule comprend :
- la détermination d'une direction et d'une vitesse de l'au moins un courant d'eau au sein de la zone immergée,
- la détermination, à partir de la direction et de la vitesse du courant d'eau, d'une direction et d'une intensité d'une contrainte de cisaillement induite par le courant d'eau, et
- la détermination que la particule est transportée ou déposée sur la base de la direction et de l'intensité déterminées de la contrainte de cisaillement, d'une granulométrie et d'un type de sédiment de la particule.

3. Procédé selon l'une quelconque des revendications précédentes, dans lequel la modélisation de la remobilisation d'une fraction des particules déposées comprend la détermination de la fraction des particules déposées qui est remobilisée pendant un événement de tempête.

4. Procédé selon la revendication 3, dans lequel la configuration comprend en outre la définition d'une vitesse du vent associée à des conditions de tempête, et la détermination de la fraction des particules déposées qui est remobilisée pendant un événement de tempête comprend :
- la détermination d'une vitesse d'au moins un courant d'eau induit par le vent au sein de la zone immergée pendant un événement de tempête,
- la détermination, à partir de la vitesse du courant d'eau, d'une valeur d'une contrainte de cisaillement induite sur les particules déposées par le courant d'eau induit par le vent et,
- la détermination de la fraction des particules déposées qui est remobilisée pendant l'événement de tempête sur la base de ladite valeur de contrainte de cisaillement.

5. Procédé selon la revendication 4, comprenant en outre une étape préliminaire de définition de couches d'eau correspondant à des plages de profondeurs d'eau respectives s'étendant entre la surface et le fond de la zone immergée, comprenant :
- une couche de fond, située au fond de l'eau,
- une couche de panache, située à la surface de l'eau, et
- une couche de subsurface, s'étendant entre le fond et la couche de panache,
et la modélisation de la remobilisation d'une fraction des particules déposées comprend la détermination d'une fraction de particules remobilisées dans chaque couche d'eau.

6. Procédé selon la revendication 5, dans lequel la détermination d'une vitesse d'au moins un courant d'eau induit par le vent au sein de la zone immergée dans des conditions de tempête comprend :
- la détermination de la vitesse d'un courant induit par le vent survenant dans la couche de panache sur la base de paramètres déduits de la vitesse du vent, et
- la détermination de la vitesse d'un courant de retour survenant dans la couche de subsurface et résultant du courant induit par le vent survenant dans la couche de panache.

7. Procédé selon la revendication 6, dans lequel la détermination d'une vitesse d'un courant induit par le vent survenant dans la couche de panache comprend la détermination d'une vitesse de l'un parmi un courant de surface océanique provoqué par un vortex d'Ekman et un courant induit par les vagues.

8. Procédé selon l'une quelconque des revendications 5 à 7, dans lequel la détermination d'une fraction de particules remobilisées dans chaque couche d'eau est basée sur la valeur de contrainte de cisaillement induite sur les particules dans la couche de fond, une valeur de contrainte de cisaillement induite sur les particules dans la couche d'eau considérée et au moins une valeur de seuil de contrainte de cisaillement.

9. Procédé selon la revendication 8, dans lequel toutes les particules remobilisées sont remobilisées dans la couche de fond si :
- la valeur de contrainte de cisaillement dans la couche de fond est supérieure à une valeur de seuil de contrainte de cisaillement de mouvement des particules, et
- la valeur de contrainte de cisaillement dans la couche de subsurface est inférieure à une valeur de seuil de contrainte de cisaillement de suspension critique des particules.

10. Procédé selon la revendication 8 ou 9, dans lequel une fraction de particules remobilisées est mise en suspension dans la couche de subsurface si :
- la valeur de contrainte de cisaillement dans la couche de fond est supérieure à une valeur de seuil de contrainte de cisaillement de mouvement des particules, et
- la valeur de contrainte de cisaillement dans la couche de subsurface est supérieure à une valeur de seuil de contrainte de cisaillement de suspension critique des particules.

11. Procédé selon l'une quelconque des revendications 8 à 10, dans lequel une fraction des particules remobilisées est mise en suspension dans la couche de panache et la couche de subsurface :
- la valeur de contrainte de cisaillement dans la couche de fond est supérieure à une valeur de seuil de contrainte de cisaillement de mouvement des particules,
- une valeur de contrainte de cisaillement dans la couche de subsurface est supérieure à une valeur de seuil de contrainte de cisaillement de suspension des particules, et
- une valeur de contrainte de cisaillement dans la couche de panache est supérieure à la valeur de seuil de contrainte de cisaillement de suspension des particules.

12. Produit-programme d'ordinateur comprenant des instructions de code pour la mise en œuvre du procédé selon l'une quelconque des revendications précédentes, lorsqu'il est exécuté par un processeur.

13. Support de stockage non transitoire lisible par ordinateur, sur lequel est stocké un programme d'ordinateur comprenant des instructions de programme, le programme d'ordinateur pouvant être chargé dans un processeur et étant adapté pour amener le processeur à exécuter, lorsque le programme d'ordinateur est exécuté par le processeur, le procédé selon l'une quelconque des revendications 1 à 11.
